(19) **Europäisches Patentamt / European Patent Office / Office européen des brevets**

(11) **EP 3 598 512 B1**

(12) **FASCICULE DE BREVET EUROPEEN**

(45) Date de publication et mention
de la délivrance du brevet:
**11.08.2021 Bulletin 2021/32**

(51) Int Cl.:
*H01L 37/02* (2006.01)    *G01J 5/34* (2006.01)

(21) Numéro de dépôt: **19186597.1**

(22) Date de dépôt: **16.07.2019**

(54) **DISPOSITIF DE DETECTION PYROELECTRIQUE A MEMBRANE SUSPENDUE CONTRAINTE**

PYROELEKTRISCHE DETEKTIONSVORRICHTUNG MIT VORGESPANNT AUFGEHÄNGTER MEMBRAN

PYROELECTRIC DETECTION DEVICE WITH STRESSED SUSPENDED MEMBRANE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.07.2018 FR 1856658**

(43) Date de publication de la demande:
**22.01.2020 Bulletin 2020/04**

(73) Titulaire: **Commissariat à l'énergie atomique et aux énergies alternatives 75015 Paris (FR)**

(72) Inventeurs:
• **LE RHUN, Gwenaël**
  **38054 Grenoble Cedex 09 (FR)**
• **FANGET, Stéphane**
  **38054 Grenoble Cedex 09 (FR)**

(74) Mandataire: **Brevalex**
  **95, rue d'Amsterdam**
  **75378 Paris Cedex 8 (FR)**

(56) Documents cités:
EP-A1- 1 998 153    WO-A2-2007/144892
JP-A- 2014 153 188    US-A1- 2013 015 353

## Description

## DOMAINE TECHNIQUE ET ART ANTÉRIEUR

L'invention porte sur un dispositif de détection pyroélectrique à membrane suspendue contrainte, ainsi qu'un procédé de réalisation d'un tel dispositif. L'invention s'applique au domaine de la détection infrarouge (IR), pour réaliser par exemple une détection de gaz ou pour former un imageur infrarouge servant par exemple à réaliser une détection de mouvement ou une détection de présence.

Dans un dispositif de détection infrarouge, un rayonnement infrarouge reçu par un matériau pyroélectrique du dispositif induit un changement de température de ce matériau. Ce changement de température entraîne une variation de polarisation du matériau pyroélectrique, créant la circulation d'un courant électrique à travers ce matériau et permettant d'obtenir, à la sortie du dispositif, une tension.

Le matériau pyroélectrique présente une polarisation spontanée dont l'amplitude varie en fonction de la température. Une variation de charges électriques peut donc être mesurée lorsque l'intensité du flux infrarouge reçu varie.

La réalisation d'un tel dispositif de détection infrarouge repose sur des procédés technologiques classiquement utilisés pour fabriquer des dispositifs MEMS (microsystème électromécanique). Le substrat utilisé comporte généralement du silicium mais d'autres matériaux peuvent être utilisés (verre, saphir, substrat souple en polymère, etc.).

Afin d'avoir une bonne isolation thermique entre le matériau pyroélectrique et le substrat et limiter ainsi les pertes par conduction thermique à travers le substrat, il est possible de graver le substrat pour former une membrane suspendue sur laquelle repose le matériau pyroélectrique. Le document « Pyroelectric thin film sensor array » de M. Kohli, Sensors and Actuators A : Physical, vol. 60, Issues 1-3, pages 147-153, Mai 1997, décrit un dispositif de détection infrarouge ainsi réalisé.

Dans le document « Design, fabrication and characterization of pyroelectric thin film and its application for infrared gas sensors » de T. Qiu-Lin et al, Microelectronics Journal, vol. 40, Issue 1, pages 58-62, Janvier 2009, il est décrit qu'un problème lié à ce type de dispositif comprenant un matériau pyroélectrique disposé sur une membrane suspendue réside dans sa sensibilité aux contraintes et vibrations mécaniques car tous les matériaux pyroélectriques sont également piézoélectriques. Un courant parasite est donc généré dans le matériau pyroélectrique à cause des contraintes et des vibrations mécaniques subies par le dispositif en raison des propriétés piézoélectriques du matériau pyroélectrique. La génération d'un tel courant parasite est appelé effet microphonique ou microphonie. Les variations de la température ambiante et de la luminosité auxquelles le détecteur est exposé génèrent également un signal parasite qui se superpose au signal de tension de sortie du détecteur correspondant à la mesure réalisée.

Une réponse possible à ces problèmes qui est proposée dans ce document est de réaliser, sur la membrane suspendue, deux éléments de détection pyroélectrique disposés côte à côte sur la membrane suspendue, formant deux empilements comprenant chacun une portion de matériau pyroélectrique disposée entre une électrode avant et une électrode arrière, de dimensions identiques et reliés électriquement en série l'un à l'autre par leurs électrodes avant. Dans cette configuration, le dispositif est peu sensible aux interférences de mode commun telles que la sensibilité à l'accélération provoquée par la vibration mécanique, car les directions de la polarisation induite dans les deux éléments de détection sont opposées. Un tel dispositif permet donc d'améliorer la capacité de détection. Toutefois, cette amélioration de la capacité de détection nécessite la réalisation de deux éléments de détection côte à côte, ce qui est encombrant et coûteux à réaliser.

Dans le document « Pyroelectric devices and materials » de R. Whatmore, Rep. Prog. Phys. 49 (1986), pages 1335-1386, d'autres solutions sont également proposées pour minimiser le bruit lié à cet effet piézoélectrique dans les dispositifs de détection infrarouge à matériau pyroélectrique. Chacune des différentes solutions proposées dans ce document présente toutefois au moins l'un des inconvénients suivants :

- besoin d'un packaging très rigide dans lequel le détecteur pyroélectrique est disposé ;
- besoin d'utiliser une structure de compensation ;
- besoin de suspendre le détecteur sur un film polymère qui tendrait à découpler le détecteur vis-à-vis des déformations liées au packaging ;
- besoin d'utiliser un matériau pyroélectrique présentant des faibles coefficients piézoélectriques.

Le document JP 2014-153188 A décrit un dispositif pyroélectrique comprenant une membrane suspendue et un élément de détection pyroélectrique disposé sur la membrane suspendue. Dans ce dispositif, la membrane est déformée de manière concave ou convexe, dans le but d'améliorer la réponse du dispositif. La déformation de la membrane est obtenue en la réalisant sous la forme d'un empilement de plusieurs couches soumises à des contraintes différentes et/ou en appliquant une pression d'un côté de la membrane pour la déformer. Cette déformation permet de diminuer la permittivité diélectrique du matériau pyroélectrique et ainsi d'augmenter la sensibilité du dispositif. Toutefois, ce dispositif n'apporte pas de solution au problème de génération de charges parasites lorsque le dispositif est soumis à un choc ou à des vibrations.

Le document EP 1 998 153 A1 décrit un dispositif pyroélectrique souple comprenant une membrane suspendue reliée à sa périphérie à un anneau rigide, et un élément de détection pyroélectrique disposé sur la membrane suspendue. Tous les éléments du dispositif sont souples afin de donner une forme souhaitée au dispositif. Un tel dispositif n'apporte donc pas non plus de solution au problème de génération de charges parasites lorsque le dispositif est soumis à un choc ou à des vibrations.

## EXPOSÉ DE L'INVENTION

Un but de la présente invention est de proposer un dispositif de détection pyroélectrique ne présentant pas les inconvénients de l'art antérieur exposés ci-dessus.

Pour cela, l'invention propose un dispositif de détection pyroélectrique, comprenant au moins :

- une membrane suspendue ;
- un élément de détection pyroélectrique disposé sur la membrane suspendue et comprenant au moins une portion de matériau pyroélectrique disposée entre des première et deuxième électrodes, la première électrode étant disposée entre la portion de matériau pyroélectrique et la membrane suspendue ;

et dans lequel la membrane et l'élément de détection pyroélectrique sont soumis à une contrainte compressive plus importante qu'une contrainte limite de flambage de la membrane et de l'élément de détection pyroélectrique et forment ensemble une structure bistable.

Le détecteur pyroélectrique proposé comporte une membrane suspendue, comprenant par exemple une ou plusieurs couches dite(s) élastique(s) permettant la tenue mécanique de la membrane pyroélectrique, et au moins un élément de détection pyroélectrique formant un condensateur à base de matériau pyroélectrique disposé entre deux électrodes. L'ensemble formé de la membrane suspendue et de l'élément de détection pyroélectrique est soumis à une contrainte compressive plus importante que la contrainte limite de flambage de cet ensemble, c'est-à-dire dont la valeur absolue est supérieure à celle de la contrainte limite de flambage, et qui engendre donc un flambage (« buckling » en anglais) de cet ensemble. Cet ensemble forme une structure bistable et se trouve dans l'un des deux états stables.

Ainsi, lorsque cet ensemble est soumis à une contrainte mécanique comme par exemple un choc, les vibrations de la membrane et de l'élément de détection pyroélectrique sont très fortement atténuées car cet ensemble est bloqué dans l'état de stabilité dans lequel il se trouve grâce à la contrainte en compression à laquelle la membrane et l'élément de détection pyroélectrique sont soumis. Les charges électriques éventuellement générées par ce choc sont alors idéalement nulles ou en tout cas très faibles voire négligeables.

Si des charges piézoélectriques sont générées, elles seront caractéristiques du « bruit » piézoélectrique et donc plus facilement identifiables. Il sera donc possible, via l'électronique de lecture, de détecter ces charges qui auront une signature particulière (en raison de l'état bistable dans lequel se trouvent la membrane suspendue et l'élément de détection pyroélectrique), et de les déduire du signal global formé par les charges liées à l'effet pyroélectrique par exemple par un traitement numérique mis en œuvre par un ordinateur.

La structure flambée permet en outre d'obtenir un meilleur alignement des dipôles ferroélectriques dans l'une des directions de polarisation up ou down, en raison de l'état de contrainte important lié au flambage, et donc une meilleur stabilité de l'état de polarisation de l'élément de détection pyroélectrique et une meilleure sensibilité de mesure du capteur.

Pour la compréhension de l'invention, il convient de noter qu'il est possible qu'un élément pyroélectrique comprenant une membrane soit déformé de manière concave ou convexe sans pour autant qu'il soit flambé. Dans ce cas, cet élément est soumis à une contrainte inférieure à la contrainte limite de flambage de cet élément. Un tel élément déformé sera par contre sensible aux vibrations mécaniques ou à la pression exercée sur celui-ci, et ne répondra pas au problème de génération de charges parasites lorsque le dispositif est soumis à un choc ou à des vibrations.

Contrairement à l'invention dans laquelle la structure bistable obtenue est bloquée dans un état de déformation concave ou convexe, une structure pyroélectrique qui n'est pas soumise à une contrainte compressive plus importante qu'une contrainte limite de flambage de cette structure n'est pas bloquée dans un état de déformation et peut être aisément déformée par application d'une contrainte mécanique (vibration, choc, pression, etc.) ou électrique (actionnement piézoélectrique).

Dans l'ensemble du document, le terme « sur » est utilisé sans distinction de l'orientation dans l'espace de l'élément auquel ce rapporte ce terme. Par exemple, dans la caractéristique « un élément de détection pyroélectrique disposé sur la membrane suspendue », la face de la membrane sur laquelle l'élément de détection pyroélectrique est disposé n'est pas nécessairement orientée vers le haut mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments.

Dans le dispositif de détection pyroélectrique, la membrane est qualifiée de suspendue car elle comporte une ou plusieurs parties, par exemple des bords, solidaires d'une partie fixe du dispositif, et une ou plusieurs autres parties, par exemple une partie centrale de la membrane, mobile vis-à-vis de cette partie fixe du dispositif. Selon un autre exemple de réalisation, la membrane peut être suspendue par des bras, c'est-à-dire que la membrane est solidaire de la partie fixe (formée par exemple par un substrat) de manière discontinue.

La membrane comporte une ou plusieurs couches de matériaux.

L'épaisseur totale de la structure bistable est par exemple comprise entre environ 100 nm et 100 $\mu$m.

La membrane et l'élément de détection pyroélectrique sont soumis à une contrainte compressive, c'est-à-dire que les matériaux de la membrane et de l'élément de détection pyroélectrique sont soumis à une ou plusieurs forces orientées telles qu'elles engendrent une contraction de ces matériaux.

La contrainte limite de flambage de la membrane et de l'élément de détection pyroélectrique correspond à la contrainte compressive ayant une valeur à partir de laquelle la membrane et l'élément de détection pyroélectrique subissent un phénomène d'instabilité transversal sous l'action de cette contrainte, lequel est appelé flambement ou flambage.

Une structure bistable correspond à une structure comprenant uniquement deux états stables mécaniquement engendrés par la contrainte compressive, c'est-à-dire le stress global compressif, de la structure membrane pyroélectrique formée par la membrane suspendue et l'élément de détection pyroélectrique.

La membrane suspendue peut comporter du $SiO_2$ et/ou du Si et/ou du SiN.

Le dispositif peut comporter en outre un substrat dans lequel est formée au moins une cavité, la membrane pouvant comporter des bords solidaires du substrat et au moins une partie suspendue disposée en regard de la cavité. Le substrat fait dans ce cas partie de la partie fixe du dispositif à laquelle la membrane est suspendue.

L'élément de détection pyroélectrique peut comporter un corps noir formé par la deuxième électrode et/ou par une portion de matériau absorbeur de rayonnement infrarouge disposée sur la deuxième électrode.

Ainsi, la deuxième électrode peut servir à la fois d'électrode et d'absorbeur de rayonnement infrarouge. Le matériau de la deuxième électrode peut être différent de celui de la première électrode, et/ou l'épaisseur de la deuxième électrode peut être différente de celle de la première électrode, notamment lorsque la deuxième électrode sert à la fois d'électrode et d'absorbeur de rayonnement infrarouge. Par exemple, la première électrode peut comporter du platine, et la deuxième électrode peut comporter un matériau configuré pour que la deuxième électrode remplisse les fonctions d'électrode et d'absorbeur de rayonnement infrarouge, comme par exemple du Ni, du Ni-Cr ou du TiN.

Le corps noir correspond à un élément absorbant l'énergie électromagnétique reçue par le dispositif de détection pyroélectrique.

Le matériau absorbeur de rayonnement infrarouge peut comporter du TiN et/ou du Ni-Cr et/ou du Ni et/ou du métal noir (noir de Platine, or noir,...).

Le dispositif peut être tel que :

- le matériau pyroélectrique correspond à au moins l'un des matériaux suivants : PZT (Titano-Zirconate de Plomb, ou $Pb(Zr_X,Ti_{1-X})O_3$), PZT dopé (Mn, La, Nb,...), AlN, KNN $((K, Na)NbO_3)$, NBT-BT $((1-x)Na_{0,5}Bi_{0,5}TiO_3- xBaTiO_3)$, PMN-PT $(Pb(Mg_{1/3}Nb_{2/3})O_3-PbTiO_3)$, LTO (Tantalate de lithium, ou $LiTaO_3$), LNO (Niobate de lithium, ou $LiNbO_3$), PVDF, et/ou
- la première électrode comporte du platine, et/ou
- la deuxième électrode comporte au moins l'un des matériaux suivants : Pt, Ru, Ir, TiW, Au, Ni, Ni-Cr, TiN.

La membrane suspendue peut être discontinue, c'est-à-dire trouée et/ou percée.

L'invention concerne également un procédé de réalisation d'un dispositif de détection pyroélectrique, comportant au moins :

- réalisation d'une membrane suspendue ;
- réalisation d'un élément de détection pyroélectrique disposé sur la membrane suspendue et comprenant au moins une portion de matériau pyroélectrique disposée entre des première et deuxième électrodes, la première électrode étant disposée entre la portion de matériau pyroélectrique et la membrane suspendue ;

et dans lequel la membrane et l'élément de détection pyroélectrique sont soumis à une contrainte compressive plus importante qu'une contrainte limite de flambage de la membrane et de l'élément de détection pyroélectrique et forment ensemble une structure bistable.

La membrane suspendue peut être obtenue en réalisant, sur un substrat, au moins une couche de matériau contraint en compression destinée à former la membrane suspendue, puis en réalisant, après la réalisation de l'élément de détection pyroélectrique sur ladite au moins une couche de matériau, au moins une cavité dans le substrat, libérant au moins une partie de la membrane qui se retrouve suspendue en regard de la cavité.

Ladite au moins une couche de matériau contraint en compression peut être réalisée par oxydation thermique du substrat qui comporte au moins un semiconducteur, et/ou par dépôt de $SiO_2$ sur le substrat.

La réalisation de l'élément de détection pyroélectrique peut comporter la mise en œuvre des étapes suivantes :

- réalisation d'au moins une première couche d'électrode sur ladite au moins une couche de matériau contraint en compression ;
- réalisation d'au moins une couche du matériau pyroélectrique sur la première couche d'électrode ;
- réalisation d'au moins une deuxième couche d'électrode sur la couche du matériau pyroélectrique ;

- structuration de chacune des première et deuxième couches d'électrodes et de la couche du matériau pyroélectrique telle que des portions restantes de ces couches forment l'élément de détection pyroélectrique.

Dans ce cas, le procédé peut comporter en outre, entre l'étape de dépôt de la deuxième couche d'électrode et l'étape de structuration, une étape de dépôt d'au moins une couche de matériau absorbeur de rayonnement infrarouge sur la deuxième couche d'électrode, et dans lequel l'étape de structuration est également mise en œuvre pour la couche de matériau absorbeur de rayonnement infrarouge telle qu'une portion restante de cette couche de matériau absorbeur de rayonnement infrarouge disposée sur la deuxième électrode fasse partie d'un corps noir de l'élément de détection pyroélectrique.

La deuxième couche d'électrode peut comporter une épaisseur et un matériau tels que la deuxième électrode fasse partie du corps noir de l'élément de détection pyroélectrique.

**BRÈVE DESCRIPTION DES DESSINS**

La présente invention sera mieux comprise à la lecture de la description d'exemples de réalisation donnés à titre purement indicatif et nullement limitatif en faisant référence aux dessins annexés sur lesquels :

- la figure 1 représente un dispositif de détection pyroélectrique selon un mode de réalisation particulier,
- les figures 2 et 3 représentent des mesures réalisées par un profilomètre de la surface du dispositif de détection pyroélectrique lorsque la membrane suspendue se trouve dans l'une ou l'autre des deux positions stables,
- les figures 4 et 5 représentent des étapes d'un procédé de réalisation d'un dispositif de détection pyroélectrique selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

**EXPOSÉ DÉTAILLÉ DE MODES DE RÉALISATION PARTICULIERS**

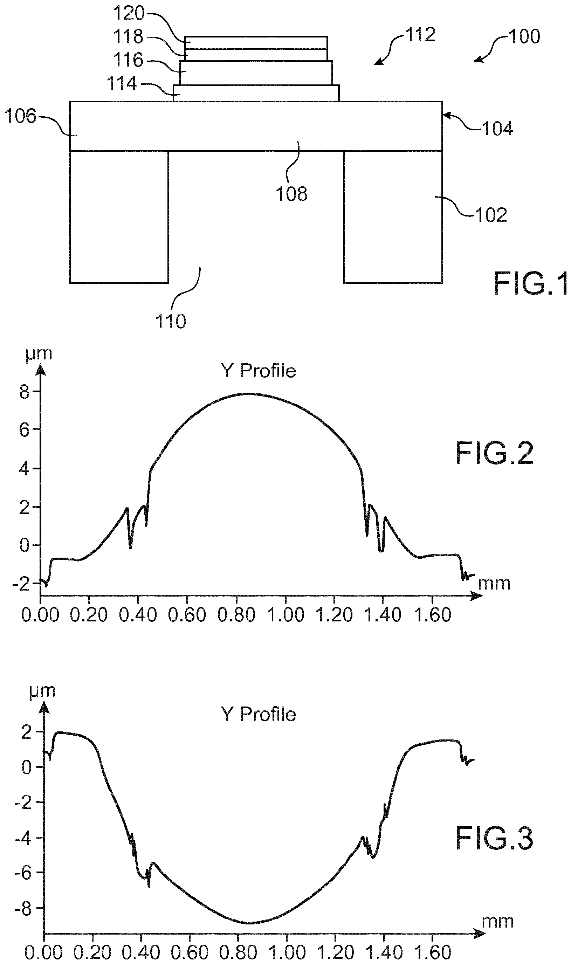

On se réfère à la figure 1 qui représente un dispositif 100 de détection pyroélectrique selon un mode de réalisation particulier.

Le dispositif 100 comporte un substrat 102. Le substrat 102 comporte avantageusement du semi-conducteur, par exemple du silicium.

Le dispositif 100 comporte également une membrane suspendue 104. Dans le mode de réalisation particulier décrit ici, la membrane 104 comporte une ou plusieurs couches comprenant au moins l'un des matériaux suivants : SiO$_2$, Si, SiN. La membrane 104 est qualifiée de suspendue car elle comporte des bords 106, ou extrémités, solidaires du substrat 102, et une partie centrale 108 libre, c'est-à-dire qui n'est pas en contact avec le substrat 102, disposée en regard d'une cavité 110 formée à travers le substrat 102.

En variante, il est possible que la membrane 104 soit suspendue au substrat 102 par l'intermédiaire de bras par exemple formés par des portions de matériau s'étendant entre certaines parties de la membrane 104 et la partie fixe du substrat 102.

Le dispositif 100 comporte également un élément de détection pyroélectrique 112 disposé sur la membrane 104. Cet élément 112 comporte :

- une électrode inférieure 114 ;
- une portion 116 de matériau pyroélectrique ;
- une électrode supérieure 118 ;
- une portion 120 de matériau absorbeur de rayonnement infrarouge.

L'électrode inférieure 114 est disposée sur la membrane 104. La portion 116 de matériau pyroélectrique est disposée entre les électrodes inférieure et supérieure 114, 118. La portion 120 de matériau absorbeur de rayonnement infrarouge est disposée sur l'électrode supérieure 118.

L'électrode inférieure 114 comporte avantageusement du platine, ce qui facilite la croissance du matériau pyroélectrique de la portion 116. L'électrode supérieure 118 comporte par exemple au moins l'un des matériaux suivants : Pt, Ru, Ir, TiW, Au. Chacune des électrodes inférieure 114 et supérieure 118 a une épaisseur par exemple comprise entre environ 10 nm et 200 nm. Bien que non visible, une couche d'adhésion peut être disposée entre la membrane 104 et l'électrode inférieure 114. Cette couche d'adhésion comprend par exemple du TiO$_2$ ou tout autre matériau adapté pour que l'électrode inférieure 114 adhère bien à la membrane 104, et a par exemple une épaisseur comprise entre environ 2 nm et 40 nm.

La portion 116 de matériau pyroélectrique comporte avantageusement du PZT, mais peut comporter plus généralement au moins l'un des matériaux suivants : PZT, AIN, KNN, NBT-BT, PMN-PT, LTO, LNO, PVDF. L'épaisseur de la portion 116 de matériau pyroélectrique est par exemple comprise entre environ 50 nm et 2 μm.

La portion 120 de matériau absorbeur comporte au moins l'un des matériaux suivants : TiN et/ou du Ni-Cr et/ou du Ni et/ou du métal noir (noir de platine, or noir, ...). L'épaisseur de la portion 120 est par exemple comprise entre environ 1 nm et 5 $\mu$m.

La membrane 104 est soumise à une contrainte compressive, ou contrainte en compression, telle que l'ensemble formé de la membrane 104 et de l'élément 112 soit soumis à une contrainte compressive plus importante que la contrainte de limite de flambage de cet ensemble, ce qui engendre un flambage de cet ensemble qui forme une structure bistable, c'est-à-dire qu'elle soit apte à se trouver dans l'une parmi deux positions stables.

Une première position stable de cet ensemble 104+112 correspond à une position selon laquelle cet ensemble 104+112 est incurvé, ou courbé, tel que la partie centrale 108 de la membrane 104 soit en dehors du plan dans lequel se trouvent les bords 106 de la membrane 104 qui sont en contact avec le substrat 102 et dépasse du côté de l'élément de détection pyroélectrique 112. Cette première position stable est représentée sur la figure 2 qui correspond à une mesure réalisée par un profilomètre de la surface du dispositif 100 se trouvant dans cette première position stable.

Une deuxième position stable de l'ensemble 104+112 correspond à une position selon laquelle cet ensemble 104+112 est incurvé, ou courbé, tel que la partie centrale 108 de la membrane 104 soit en dehors du plan dans lequel se trouvent les bords 106 de la membrane 104 qui sont en contact avec le substrat 102 et dépasse du côté de la cavité 110. Cette deuxième position stable est représentée sur la figure 3 qui correspond à une mesure réalisée par un profilomètre de la surface du dispositif 100 se trouvant dans cette deuxième position stable.

Pour obtenir le flambage de l'ensemble formé de la membrane 104 et de l'élément de détection pyroélectrique 112 et que celui-ci forme une structure bistable, les paramètres mécaniques des couches formant cet ensemble sont choisis de manière appropriée pour obtenir ce résultat. Les paramètres considérés et choisis judicieusement sont :

- les dimensions et notamment l'épaisseur des différentes couches de la membrane 104 et de l'élément de détection pyroélectrique 112 ;
- la valeur de la contrainte des différentes couches de la membrane 104 et de l'élément de détection pyroélectrique 112 ;
- le module de Young et le coefficient de Poisson des matériaux des différentes couches de la membrane 104 et de l'élément de détection pyroélectrique 112.

La contrainte limite de flambage $\sigma_{limite\_flambage}$ pour une structure membrane monocouche circulaire est donnée par la formule suivante :

$$\sigma_{limite\_flambage} = 14{,}68.\frac{D}{r^2.t.10^6}$$

$$D = E.\frac{t^3}{12.(1-\vartheta^2)}$$

Avec

Où D est la rigidité de flexion, r est le rayon de la membrane, t est l'épaisseur de la membrane, E est le module d'Young et $\vartheta$ est le coefficient de Poisson. Pour une structure multicouches, comme c'est le cas ici avec l'ensemble formé de la membrane 104 et de l'élément de détection pyroélectrique 112, sa contrainte limite de flambage est calculée en rapportant cet ensemble en première approximation à une structure monocouche équivalente avec des paramètres mécaniques (module d'Young, coefficient de Poisson, contrainte) calculés par la moyenne pondérée par le rapport d'épaisseur de chaque couche sur l'épaisseur totale, soit pour n couches :

$$Eeq = \frac{\sum_{i=1}^{n} tiEi}{\sum_{i=1}^{n} ti},$$

le module d'Young équivalent,

$$veq = \frac{\sum_{i=1}^{n} tivi}{\sum_{i=1}^{n} ti},$$

le coefficient de Poisson équivalent,

$$\sigma eq = \frac{\sum_{i=1}^{n} ti\sigma i}{\sum_{i=1}^{n} ti},$$

la contrainte équivalente.

Par exemple, pour un dispositif 100 comprenant :

- une membrane 104 suspendue de forme circulaire, de rayon égal à 400 $\mu$m et formée par une couche élastique de SiO$_2$ d'épaisseur égale à 1 $\mu$m (E = 70 GPa, $\nu$ = 0,18, $\sigma$ = -200 MPa),
- une électrode inférieure 114 comprenant du platine et d'épaisseur égale à 0,1 $\mu$m (E = 180 GPa, $\nu$ = 0,3, $\sigma$ = 600 MPa),
- une portion 116 de PZT et d'épaisseur égale à 0,5 $\mu$m (E = 80 GPa, $\nu$ = 0,39, $\sigma$ = 50 MPa),
- une électrode supérieure 118 comprenant du platine et d'épaisseur égale à 0,05 $\mu$m (E = 180 GPa, $\nu$ = 0,3, $\sigma$ = 100 MPa), et
- une portion 120 comprenant du TiN et d'épaisseur égale à 0,05 $\mu$m (E = 360 GPa, $\nu$ = 0,3, $\sigma$ = 1000 MPa),

la contrainte (en compression) limite de flambage calculée est égale à -2 MPa. Or, la contrainte équivalente de l'empilement étant de -35 MPa, donc supérieure (en valeur absolue) à la contrainte limite de flambage, la membrane 104 et l'élément 112 sont flambés.

Le passage de l'un à l'autre des deux états stables de la membrane 104 est possible en appliquant, aux bornes des première et deuxième électrodes 114, 118, une tension relativement importante, par exemple comprise entre environ 10 V et 20 V et/ou en appliquant une contrainte mécanique suffisamment importante (correspondant donc à une force supérieure à celle maintenant la membrane 104 dans l'une de ses deux positions stables) sur l'une des faces principales de la membrane 104 en fonction de la position stable dans laquelle la membrane 104 est destinée à être positionnée.

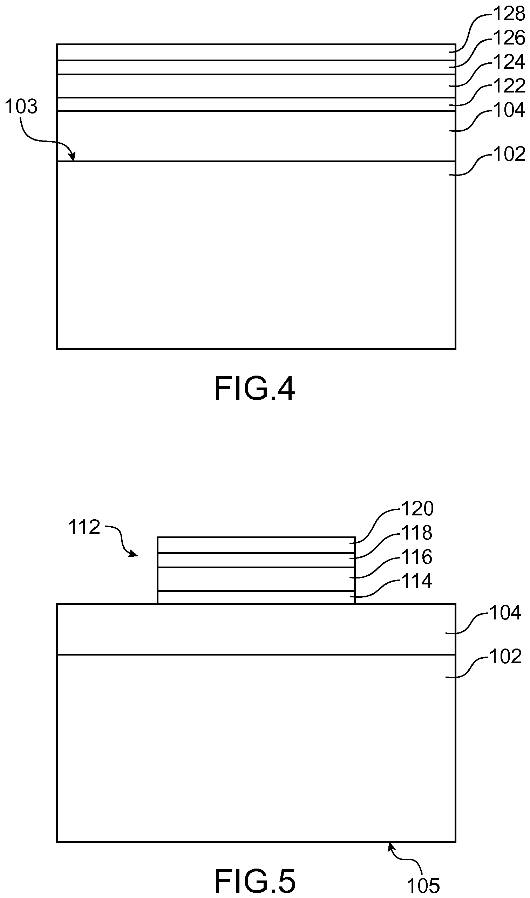

Un exemple d'un procédé de réalisation du dispositif 100 est décrit ci-dessous en lien avec les figures 4 et 5.

Comme représenté sur la figure 4, une (ou plusieurs) couche 104 de matériau contraint en compression destinée à former la membrane suspendue est réalisée sur une face avant 103 du substrat 102. Dans l'exemple de réalisation décrit ici, le substrat 102 comporte du silicium et la couche 104 comporte du SiO$_2$. Selon un premier exemple, la couche 104 peut être réalisée par oxydation thermique depuis la face avant 103 du substrat 102. Selon un deuxième exemple, la couche 104 peut être formée par un dépôt, par exemple PECVD (dépôt chimique en phase vapeur assisté par plasma), de SiO$_2$, avantageusement suivi d'une densification correspondant par exemple à un recuit dans un four sous oxygène, à une température par exemple égale à environ 800°C et pendant une durée égale à environ 3 heures. La couche 104 ainsi réalisée est en compression en raison de l'état de contrainte compressif inhérent au SiO$_2$.

Au moins une première couche d'électrode 122 destinée à former l'électrode inférieure 114 est ensuite déposée sur la couche 104. Dans l'exemple de réalisation décrit ici, la première couche d'électrode 122 comporte du platine. De manière avantageuse, le dépôt de cette première couche d'électrode 122 est précédé d'un dépôt d'une couche d'accroche (non visible sur la figure 4) correspondant par exemple à une couche de TiO$_2$ déposée sur la couche 104, la première couche d'électrode 122 étant ensuite déposée sur cette couche d'accroche.

Au moins une couche 124 du matériau pyroélectrique destinée à former la portion 116 de matériau pyroélectrique est ensuite déposée sur la première couche d'électrode 122. Cette couche 124 est par exemple formée par un procédé de type sol-gel ou par pulvérisation cathodique ou encore par ablation laser pulsé.

Au moins une deuxième couche d'électrode 126, comprenant par exemple du platine, destinée à former l'électrode supérieure 118 est ensuite déposée sur la couche 124.

Une couche 128 de matériau absorbeur de rayonnement infrarouge destinée à former la portion 120 est ensuite déposée sur la deuxième couche d'électrode 126.

Une structuration de chacune des couches 122, 124, 126 et 128 est ensuite mise en œuvre, par exemple par lithographie, gravure et stripping, telle que les portions restantes 114, 116, 118 et 120 de ces couches forment l'élément 112 de détection pyroélectrique (voir figure 5).

Le dispositif 100 est achevé en formant, depuis une face arrière 105 du substrat 102, la cavité 110 permettant de libérer la partie centrale 108 de la membrane 104. Cette gravure correspond par exemple à une gravure ionique réactive profonde (DRIE). Le dispositif 100 obtenu correspond à celui représenté sur la figure 1.

Selon une variante de réalisation, la ou les couches de la membrane suspendue 104 peut ou peuvent être discontinues, c'est-à-dire trouées et/ou percées.

## Revendications

1. Dispositif (100) de détection pyroélectrique, comprenant au moins :

   - une membrane (104) suspendue ;
   - un élément (112) de détection pyroélectrique disposé sur la membrane (104) suspendue et comprenant au moins une portion (116) de matériau pyroélectrique disposée entre des première et deuxième électrodes (114, 118), la première électrode (114) étant disposée entre la portion (116) de matériau pyroélectrique et la membrane (104) suspendue ;

   et dans lequel la membrane (104) et l'élément (112) de détection pyroélectrique sont soumis à une contrainte compressive ;
   **caractérisé en ce que** la contrainte compressive est plus importante qu'une contrainte limite de flambage de la membrane (104) et de l'élément (112) de détection pyroélectrique et **en ce que** la membrane (104) et l'élément (112) de détection pyroélectrique forment ensemble une structure bistable.

2. Dispositif (100) selon la revendication 1, dans lequel la membrane (104) suspendue comporte du SiO$_2$ et/ou du Si et/ou du SiN.

3. Dispositif (100) selon l'une des revendications précédentes, comportant en outre un substrat (102) dans lequel est formée au moins une cavité (110), la membrane (104) comprenant des bords (106) solidaires du substrat (102) et au moins une partie (108) suspendue disposée en regard de la cavité (110).

4. Dispositif (100) selon l'une des revendications précédentes, dans lequel l'élément (112) de détection pyroélectrique comporte un corps noir formé par la deuxième électrode (118) et/ou par une portion (120) de matériau absorbeur de rayonnement infrarouge disposée sur la deuxième électrode (118).

5. Dispositif (100) selon la revendication 4, dans lequel le matériau absorbeur de rayonnement infrarouge comporte du TiN et/ou du Ni-Cr et/ou du Ni et/ou du métal noir (noir de platine, or noir).

6. Dispositif (100) selon l'une des revendications précédentes, dans lequel :

   - le matériau pyroélectrique correspond à au moins l'un des matériaux suivants : PZT, AIN, KNN, NBT-BT, PMN-PT, LTO, LNO, PVDF et/ou
   - la première électrode (114) comporte du platine, et/ou
   - la deuxième électrode (118) comporte au moins l'un des matériaux suivants : Pt, Ru, Ir, TiW, Au, Ni, Ni-Cr, TiN.

7. Procédé de réalisation d'un dispositif (100) de détection pyroélectrique, comportant au moins :

   - réalisation d'une membrane (104) suspendue ;
   - réalisation d'un élément (112) de détection pyroélectrique disposé sur la membrane (104) suspendue et comprenant au moins une portion (116) de matériau pyroélectrique disposée entre des première et deuxième électrodes (114, 118), la première électrode (114) étant disposée entre la portion (116) de matériau pyroélectrique et la membrane (104) suspendue ;

   et dans lequel la membrane (104) et l'élément (112) de détection pyroélectrique sont soumis à une contrainte compressive ;
   **caractérisé en ce que** la contrainte compressive est plus importante qu'une contrainte limite de flambage de la membrane (104) et de l'élément (112) de détection pyroélectrique et **en ce que** la membrane (104) et l'élément (112) de détection pyroélectrique forment ensemble une structure bistable.

8. Procédé selon la revendication 7, dans lequel la membrane (104) suspendue est obtenue en réalisant, sur un substrat (102), au moins une couche (104) de matériau contraint en compression destinée à former la membrane (104) suspendue, puis en réalisant, après la réalisation de l'élément (112) de détection pyroélectrique sur ladite au moins une couche (104) de matériau, au moins une cavité (110) dans le substrat (102), libérant au moins une partie (108) de la membrane (104) qui se retrouve suspendue en regard de la cavité (110).

9. Procédé selon la revendication 8, dans lequel ladite au moins une couche (104) de matériau contraint en compression est réalisée par oxydation thermique du substrat (102) qui comporte au moins un semi-conducteur, et/ou par dépôt de $SiO_2$ sur le substrat (102).

10. Procédé selon l'une des revendications 8 et 9, dans lequel la réalisation de l'élément (112) de détection pyroélectrique comporte la mise en œuvre des étapes suivantes :

   - réalisation d'au moins une première couche d'électrode (122) sur ladite au moins une couche (104) de matériau contraint en compression ;
   - réalisation d'au moins une couche (124) du matériau pyroélectrique sur la première couche d'électrode (122) ;
   - réalisation d'au moins une deuxième couche d'électrode (126) sur la couche (124) du matériau pyroélectrique ;
   - structuration de chacune des première et deuxième couches d'électrodes (122, 126) et de la couche (124) du matériau pyroélectrique telle que des portions restantes (114, 116, 118) de ces couches (122, 124, 126) forment l'élément (112) de détection pyroélectrique.

11. Procédé selon la revendication 10, comportant en outre, entre l'étape de dépôt de la deuxième couche d'électrode (126) et l'étape de structuration, une étape de dépôt d'au moins une couche (128) de matériau absorbeur de rayonnement infrarouge sur la deuxième couche d'électrode (126), et dans lequel l'étape de structuration est également mise en œuvre pour la couche (128) de matériau absorbeur de rayonnement infrarouge telle qu'une portion restante (120) de cette couche (128) de matériau absorbeur de rayonnement infrarouge disposée sur la deuxième électrode (118) fasse partie d'un corps noir de l'élément (112) de détection pyroélectrique.

12. Procédé selon l'une des revendications 10 et 11, dans lequel la deuxième couche d'électrode (126) comporte une épaisseur et un matériau tels que la deuxième électrode (118) fasse partie du corps noir de l'élément (112) de détection pyroélectrique.

**Patentansprüche**

1. Pyroelektrische Detektionsvorrichtung (100), zumindest enthaltend:

   - eine abgehängte Membran (104);
   - ein pyroelektrisches Detektionselement (112), das an der abgehängten Membran (104) angeordnet ist und zumindest einen Abschnitt (116) aus pyroelektrischem Material enthält, der zwischen einer ersten und einer zweiten Elektrode (114, 118) angeordnet ist, wobei die erste Elektrode (114) zwischen dem Abschnitt (116) aus pyroelektrischem Material und der abgehängten Membran (104) angeordnet ist;

wobei die Membran (104) und das pyroelektrische Detektionselement (112) einer Druckspannung ausgesetzt sind;

**dadurch gekennzeichnet, dass** die Druckspannung größer ist als eine Knickgrenzspannung der Membran (104) und des pyroelektrischen Detektionselements (112) und dass die Membran (104) und das pyroelektrische Detektionselement (112) zusammen eine bistabile Struktur bilden.

2. Vorrichtung (100) nach Anspruch 1, wobei die abgehängte Membran (104) SiO$_2$ und/oder Si und/oder SiN enthält.

3. Vorrichtung (100) nach einem der vorhergehenden Ansprüche, ferner enthaltend ein Substrat (102), in dem zumindest ein Hohlraum (110) ausgebildet ist, wobei die Membran (104) Ränder (106), die fest mit dem Substrat (102) verbunden sind, und zumindest einen abgehängten Abschnitt (108) aufweist, der dem Hohlraum (110) gegenüberliegend angeordnet ist.

4. Vorrichtung (100) nach einem der vorhergehenden Ansprüche, wobei das pyroelektrische Detektionselement (112) einen schwarzen Körper aufweist, der aus der zweiten Elektrode (118) und/oder aus einem auf der zweiten Elektrode (118) angeordneten Abschnitt (120) aus Infrarotstrahlung absorbierendem Material gebildet ist.

5. Vorrichtung (100) nach Anspruch 4, wobei das Infrarotstrahlung absorbierende Material TiN und/oder Ni-Cr und/oder Ni und/oder Schwarzmetall (Platinmohr, Schwarzgold) enthält.

6. Vorrichtung (100) nach einem der vorhergehenden Ansprüche, wobei:

   - das pyroelektrische Material zumindest einem der folgenden Materialien entspricht: PZT, AIN, KNN, NBT-BT, PMN-PT, LTO, LNO, PVDF und/oder
   - die erste Elektrode (114) Platin enthält, und/oder
   - die zweite Elektrode (118) zumindest eines der folgenden Materialien enthält: Pt, Ru, Ir, TiW, Au, Ni, Ni-Cr, TiN.

7. Verfahren zur Herstellung einer pyroelektrischen Detektionsvorrichtung (100), zumindest umfassend:

   - Ausbilden einer abgehängten Membran (104);
   - Ausbilden eines pyroelektrischen Detektionselements (112), das an der abgehängten Membran (104) angeordnet ist und zumindest einen Abschnitt (116) aus pyroelektrischem Material enthält, der zwischen einer ersten und einer zweiten Elektrode (114, 118) angeordnet ist, wobei die erste Elektrode (114) zwischen dem Abschnitt (116) aus pyroelektrischem Material und der abgehängten Membran (104) angeordnet ist;

wobei die Membran (104) und das pyroelektrische Detektionselement (112) einer Druckspannung ausgesetzt sind;

**dadurch gekennzeichnet, dass** die Druckspannung größer ist als eine Knickgrenzspannung der Membran (104) und des pyroelektrischen Detektionselements (112) und dass die Membran (104) und das pyroelektrische Detektionselement (112) zusammen eine bistabile Struktur bilden.

8. Verfahren nach Anspruch 7, wobei die abgehängte Membran (104) erhalten wird, indem auf einem Substrat (102) zumindest eine Schicht (104) aus druckbeanspruchtem Material zur Bildung der abgehängten Membran (104) ausgebildet wird und dann nach dem Ausbilden des pyroelektrischen Detektionselements (112) auf der zumindest einen Materialschicht (104) zumindest ein Hohlraum (110) in dem Substrat (102) ausgebildet wird, wodurch zumindest ein Teil (108) der Membran (104), der gegenüber dem Hohlraum (110) abgehängt ist, freigegeben wird.

9. Verfahren nach Anspruch 8, wobei die zumindest eine Schicht (104) aus druckbeanspruchtem Material durch thermische Oxidation des Substrats (102), das zumindest einen Halbleiter aufweist, und/oder durch Abscheidung von SiO$_2$ auf dem Substrat (102) gebildet wird.

10. Verfahren nach einem der Ansprüche 8 und 9, wobei das Ausbilden des pyroelektrischen Detektionselements (112) das Ausführen der folgenden Schritte umfasst:

   - Ausbilden zumindest einer ersten Elektrodenschicht (122) auf der zumindest einen Schicht (104) aus druckbeanspruchtem Material;
   - Ausbilden zumindest einer Schicht (124) aus pyroelektrischem Material auf der ersten Elektrodenschicht (122);
   - Ausbilden zumindest einer zweiten Elektrodenschicht (126) auf der Schicht (124) aus pyroelektrischem Material;
   - Strukturieren jeder der ersten und der zweiten Elektrodenschicht (122, 126) und der Schicht (124) aus pyroelektrischem Material, so dass verbleibende Abschnitte (114, 116, 118) dieser Schichten (122, 124, 126) das pyroelektrische Detektionselement (112) bilden.

11. Verfahren nach Anspruch 10, ferner umfassend zwischen dem Schritt des Abscheidens der zweiten Elektrodenschicht (126) und dem Schritt des Strukturierens einen Schritt des Abscheidens zumindest einer Schicht (128) aus Infrarotstrahlung absorbierendem Material auf der zweiten Elektrodenschicht (126), wobei der Schritt des Strukturierens auch für die Schicht (128) aus Infrarotstrahlung absorbierendem Material ausgeführt wird, so dass ein verbleibender Abschnitt (120) dieser Schicht (128) aus Infrarotstrahlung absorbierendem Material, der an der zweiten Elektrode (118) angeordnet ist, einen Teil eines schwarzen Körpers des pyroelektrischen Detektionselements (112) bildet.

12. Verfahren nach einem der Ansprüche 10 und 11, wobei die zweite Elektrodenschicht (126) eine solche Dicke und ein solches Material aufweist, dass die zweite Elektrode (118) einen Teil des schwarzen Körpers des pyroelektrischen Detektionselements (112) bildet.

**Claims**

1. Pyroelectric detection device (100), comprising at least:

   - a suspended membrane (104);
   - a pyroelectric detection element (112) located on the suspended membrane (104) and comprising at least one portion (116) of pyroelectric material located between first and second electrodes (114, 118), the first electrode (114) being located between the portion (116) of pyroelectric material and the suspended membrane (104);

   and in which the membrane (104) and the pyroelectric detection element (112) are subjected to a compression stress ;
   **characterized in that** the compression stress is higher than a limiting buckling stress of the membrane (104) and the pyroelectric detection element (112) and **in that** the membrane (104) and the pyroelectric detection element (112) together form a bistable structure.

2. Device (100) according to claim 1, wherein the suspended membrane (104) comprises $SiO_2$ and/or Si and/or SiN.

3. Device (100) according to one of previous claims, also comprising a substrate (102) in which at least one cavity (110) is formed, the membrane (104) comprising edges (106) fixed to the substrate (102) and at least one suspended part (108) located facing the cavity (110).

4. Device (100) according to one of previous claims, wherein the pyroelectric detection element (112) comprises a black body formed by the second electrode (118) and/or by a portion (120) of material absorbing infrared radiation located on the second electrode (118).

5. Device (100) according to claim 4, wherein the material absorbing infrared radiation comprises TiN and/or Ni-Cr and/or Ni and/or black metal (platinum black, black gold).

6. Device (100) according to one of previous claims, wherein :

   - the pyroelectric material corresponds to at least one of the following materials: PZT, AlN, KNN, NBT-BT, PMN-PT, LTO, LNO, PVDF and/or
   - the first electrode (114) comprises platinum, and/or
   - the second electrode (118) comprises at least one of the following materials: Pt, Ru, Ir, TiW, Au, Ni, Ni-Cr, TiN.

7. Method of fabricating a pyroelectric detection device (100), comprising at least:

   - fabrication of a suspended membrane (104);
   - fabrication of a pyroelectric detection element (112) located on the suspended membrane (104) and comprising at least one portion (116) of pyroelectric material located between first and second electrodes (114, 118), the first electrode (114) being located between the portion (116) of pyroelectric material and the suspended membrane (104);

   and in which the membrane (104) and the pyroelectric detection element (112) are subjected to a compression stress ;
   **characterized in that** the compression stress is higher than a limiting buckling stress of the membrane (104) and the pyroelectric detection element (112) and **in that** the membrane (104) and the pyroelectric detection element (112) together form a bistable structure.

8. Method according to claim 7, wherein the suspended membrane (104) is obtained by making at least one layer (104) of material stressed in compression intended to form the suspended membrane (104) on a substrate (102), then after making the pyroelectric detection element (112) on said at least one layer (104) of material, making at least one cavity (110) in the substrate (102), releasing at least part (108) of the membrane (104) that is suspended facing said the cavity (110).

9. Method according to claim 8, wherein said at least one layer (104) of material stressed in compression is made by thermal oxidation of the substrate (102) that comprises at least one semiconductor, and/or by deposition of $SiO_2$ on the substrate (102).

10. Method according to one of claims 8 and 9, wherein fabrication of the pyroelectric detection element (112) includes the following steps:

   - fabrication of at least one first electrode layer (122) on said at least one layer (104) of material stressed in compression;
   - fabrication of at least one layer (124) of pyroelectric material on the first electrode layer (122);
   - fabrication of at least one second electrode layer (126) on the layer (124) of pyroelectric material;
   - structuring of each of the first and second electrode layers (122, 126) and of the layer (124) of pyroelectric material such that remaining portions (114, 116, 118) of these layers (122, 124, 126) form the pyroelectric detection element (112).

11. Method according to claim 10, also comprising a step to deposit at least one layer (128) of material absorbing infrared radiation on the second electrode layer (126) between the step to deposit the second electrode layer (126) and the structuring step, and wherein the structuring step is also carried out for the layer (128) of material absorbing infrared radiation such that a remaining portion (120) of this layer (128) of material absorbing infrared radiation located on the second electrode (118) forms part of a black body of the pyroelectric detection element (112).

12. Method according to one of claims 10 and 11, wherein the second electrode layer (126) comprises a thickness and a material such that the second electrode (118) forms part of the black body of the pyroelectric detection element (112).

FIG.1

FIG.2

FIG.3

128
126
124
122
104

103

102

# FIG.4

120
118
116
114

112

104

102

105

# FIG.5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2014153188 A
- EP 1998153 A1

**Littérature non-brevet citée dans la description**

- **M. KOHLI.** Pyroelectric thin film sensor array. *Sensors and Actuators A : Physical,* Mai 1997, vol. 60 (1-3), 147-153
- **T. QIU-LIN et al.** Design, fabrication and characterization of pyroelectric thin film and its application for infrared gas sensors. *Microelectronics Journal,* Janvier 2009, vol. 40 (1), 58-62
- **R. WHATMORE.** Pyroelectric devices and materials. *Rep. Prog. Phys.,* 1986, vol. 49, 1335-1386